# EUROPEAN PATENT SPECIFICATION

(11) **EP 0 280 074 B1**
(45) Date of publication and mention of the grant of the patent: **20.12.1995**
(21) Application number: 88101468.2
(22) Date of filing: 02.02.1988
(51) Int. Cl.: H01J 37/32

(54) **Plasma reactor**
Plasmareaktor
Réacteur à plasma

(30) Priority: 24.02.1987 US 18233
(43) Date of publication of application: 31.08.1988
(73) Proprietor: International Business Machines Corporation, Armonk, N.Y. 10504 (US)
(72) Inventor: Susko, Robin Anne, Owego, N.Y. 13827 (US); Wilson, James Warren, South Vestal, N.Y. 13850 (US)
(74) Representative: Schäfer, Wolfgang, Dipl.-Ing.

(56) References cited:
- US-A- 4 282 077
- US-A- 4 361 441
- US-A- 4 394 162
- US-A- 4 474 659
- US-A- 4 482 419
- US-A- 4 559 901

## Description

The present invention relates to reactor providing a uniform field of energized gas.

In the manufacture of many electronic components, such as integrated circuits and semiconductor devices, there is a need to deposit material onto, and etch material from, substrates. In particular, metal such as copper is often deposited and material such as epoxy glass is often removed.

In the field of plasma deposition, an atom may be displaced from the surface of the target connected to a cathode by a process called sputtering or sputter deposition. In this process, the target may be constructed of copper or of another material. The cathode to which the target is attached is subjected to a high voltage in an inert atmosphere such as argon. The inert gas is ionized, forming a plasma from which positive ions escape to bombard the exposed surface of the target and to dislodge by momentum transfer the atoms or clusters of atoms of the target material. It is this dislodging of the target atoms that is known as sputtering. By repeating this process, a number of these primarily neutral atoms move through the space in front of the target, in a relatively high vacuum, until they strike and condense on the surface of a receiver, known as a sample, substrate or workpiece, which is generally in close proximity to the target. A coating of atomic or molecular layers of target material can thus be built up on the substrate. The coating, which is generally less than 10 »m, is generally sufficient for the metallization of integrated circuits.

The most commonly used plasma reactors have one or more targets oriented such that the surface of the target is parallel to the surface of the sample on which atoms are to be deposited. Atoms emitted from the target tend to be emitted in a non-uniform distribution. In particular, atoms around the edges of the target are not emitted at the same rate as atoms in the center of the target. Accordingly, the deposition of material on the substrate proximate the target is not uniform. Atoms that are ejected from the target perpendicularly and received at the sample surface perpendicularly provide optimum atom deposition thereof. A greater amount of material may be built up in the center of the substrate than at its edges.

US Patent No. 4,474,659 discloses a plasma deposition tool with power electrodes comprising specifically arranged apertures. Gas for plasma generation is applied to flow through these apertures yielding a plurality of gas streams resulting in a uniform deposition of sputtered material onto the substrate.

In etching processes, it has been found that material is etched to a greater extent along the periphery of a substrate than in the interior portions thereof. Substrates used to make printed circuit boards and cards, because they are large, are especially susceptible to non-uniformity of a plasma field, resulting in non-uniform etching, non-uniform deposition and/or non-uniform cleaning of thru holes or viaduct holes (commonly called vias). Vias are paths for electrical interconnections between a first-level conductive pattern and a second- or higher-level conductive pattern. Cleaning of thru holes is referred to as desmearing. In the etching process, for example, a more intense plasma field along the periphery of a workpiece results in a higher etching rate for that portion of the workpiece, whereas a relatively sparse plasma density in the center of the workpiece results in a predictably low etch rate for those sections. It has been found that non-uniformity of an electric field in proximity to a printed circuit board results in non-uniform plasma treatment thereof.

A dry etching apparatus comprising etching chambers of different etching rate distributions is disclosed in US Patent No 4,482,419. An object is etched in several chambers, each having different non-uniformity characteristics. In sum finally uniformity results if the individual chamber characteristics are adjusted to compensate each other. Modification of etching characteristics is achieved by means of power electrodes comprising apertures for directing gas flow onto the target substrate.

Decreasing the surface area of an electrode results in a more uniform electric field and corresponding plasma field around it. Unfortunately, for larger workpieces such as printed circuit boards and relatively large semiconductor devices, a small electrode is not economically feasible. A series of smaller electrodes, or a segmented electrode, however, in accordance with the present invention can solve the problem of non-uniform plasma field.

United States Patent Nos. 4,361,441 and 4,394,162 issued to Tylko disclose a plasma reactor having spaced stationary electrode structures of which at least one is annular. Between the electrodes an arc is established by a power supply. The arc is pulsated and caused to orbit or circulate around the annular electrode structure to form a conical plasma zone between the electrodes while particulate solids are introduced to the plasma zone. Such apparatus is a possible alternative to industrial processes such as the manufacture of steel, ferro-alloys and cements. The use of a conical plasma zone, however, is not especially useful for plasma processing of electronic components such as generally planar printed circuit boards and semiconductor devices.

United States Patent No. 4,282,077 issued to Reavill discloses a generally planar electrode plasma reaction chamber, each of a plurality of electrodes being individually connected to a radio frequency (rf) power generator. The electrodes are arranged for defining separate part cells with means for individually and separately adjusting each of the cells.

United States co-pending patent application serial number 894,240, filed August 4, 1986 for "Side Source Center Sink Plasma Reactor" assigned to the present assignee, teaches the use of a plurality of planar electrodes in a continuous plasma etching system in which the plasma reactor chamber has provision for continuously introducing a gas and for forcing the gas through one or more thru holes in the substrates in order to remove material therefrom.

It is an object of the invention to provide a plasma reactor system for generating plasma fields of improved uniformity.

It is another object of the invention to provide a plasma reactor system for generating plasma fields of improved uniformity over a workpiece.

It is still another object of the invention to provide a system for etching material from relatively large substrates uniformly.

It is still another object of the invention to provide a system for depositing material onto a substrate in a uniform manner.

It is a further object of the invention to provide a plasma system for uniformly desmearing or etching semiconductor devices.

These objects are achieved by reactors as disclosed in claim 1.

Advantageous embodiments of the inventive reactors are disclosed in the subclaims.

The Figures do not show movable electrodes and therefore not embodiments of the present invention. However, a complete understanding of the present invention may be obtained by reference to the accompanying drawings, when taken in conjunction with the detailed description thereof and in which:
- FIGURE 1: is an isometric view of a plasma reactor;
- FIGURE 2: is a plan view of an electrode structure similar to the one shown in FIGURE 1;
- FIGURE 3: is a plan view of an electrode in a concentric configuration;
- FIGURE 4: is a plan view of an electrode having outer segments partially surrounding a central segment;
- FIGURE 5: is a cross-sectional view of electrode segments in ever-increasingly radiating positions relative to one another; and
- FIGURE 6: is a cross-sectional view of electrode segments shown in an alternate spatial relationship with respect to one another.

### DETAILED DESCRIPTION OF THE PREFERRED EMBODIMENT

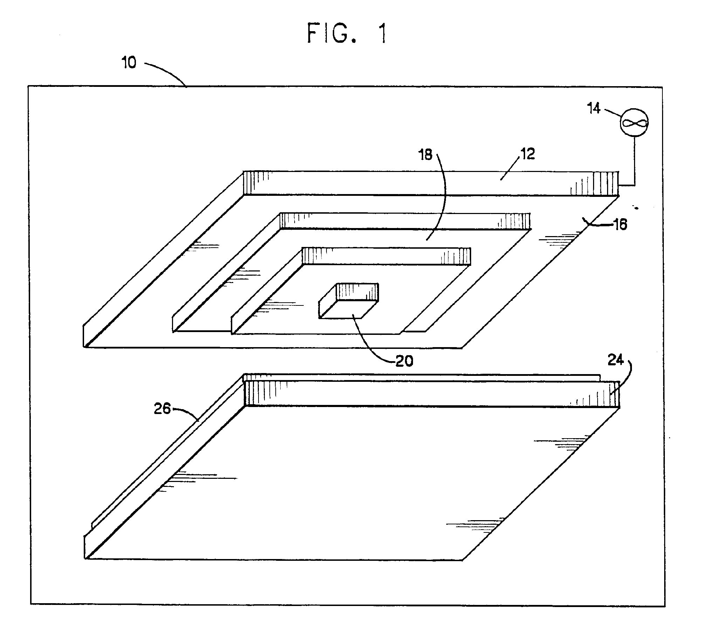

Referring now to FIGURE 1, there is shown a plasma reactor chamber 10 capable of sustaining a vacuum. Such a chamber is available from Leybold-Heraeus as model number Z-600.

Mounted in the chamber 10 by suitable means, not shown, is an electrode structure 12. The electrode structure 12 has a radio frequency power supply 14 attached thereto. Such a power supply 14 is available from Huttinger, Inc. as model number IS2.5/13560.

The electrode structure 12 has a number of electrode subunits or segments attached to it. The electrode segments are shown as reference numerals 16-20 and are described in greater detail hereinbelow.

Disposed beneath the electrode structure 12 is a platform or sample holder 24. Two electrodes are normally required for sustaining a plasma reaction. One of the electrodes can be either the platform 24 or the vacuum chamber wall 10. The platform 24 is a conventional sample holder or mounting mechanism on which is mounted a workpiece 26. The workpiece 26 can be a printed circuit board, a semiconductor device or any structure to be etched or on which material is to be deposited. The workpiece 26 is electrically grounded in a preferred embodiment, but need not be when a fixed or floating potential is desired.

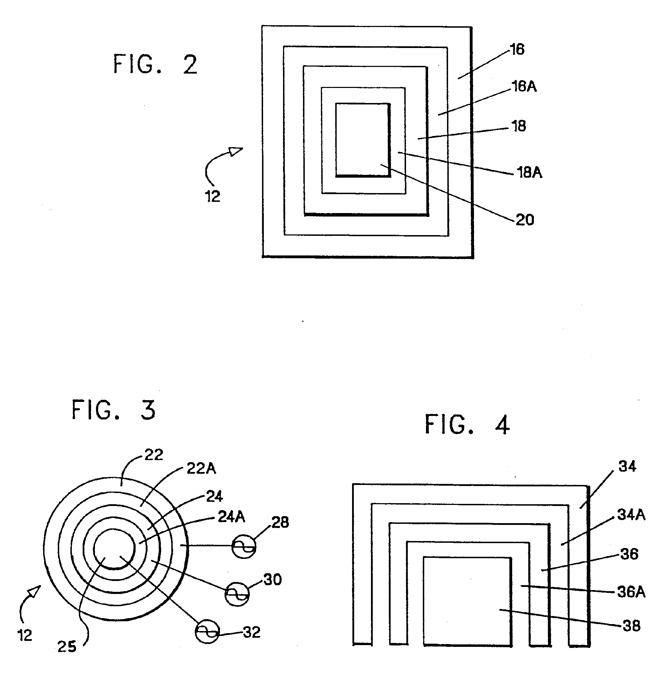

Referring now also to FIGURE 2, there is shown an electrode structure similar to the one of FIGURE 1. The segmented electrode structure is shown at reference numeral 12. An outer electrode 16 in the shape of a rectangle is connected to a first power supply, not shown. A second electrode 18 is disposed within the first electrode 16 and is shaped identically to the first electrode 16, but smaller in both dimensions. A space 16A between the first electrode 16 and the second electrode 18 prevents an unwanted electrical connection or short circuit between the two electrodes 16 and 18 and allows each of them to be energized independently. Any dielectric or electrically non-conductive material, not shown, can fulfill the function of the air gap 16A wherever such gaps are shown in the embodiments hereinbelow depicted. Such material can add stability to the electrode structure and may facilitate the manufacture thereof.

A second power supply, not shown, is attached to the second electrode 18. Such a second power supply can be actuated independently of the first power supply, not shown, to energize the second electrode 18 independently of the first electrode 16.

In a like manner, a third electrode 20 is nested within the second electrode 18 and separated therefrom by a gap 18A to provide electrical insulation therebetween. A third power supply, not shown, is attached to the third electrode 20.

Referring now also to FIGURE 3 there is shown a plan view of an alternate example of the electrode structure 12 shown in a concentric configuration. An outer electrode segment 22 forms a circle in which is disposed a smaller circular segment 24 separated by a gap or space 22A. Within the second segment 24 is a third segment 26 separated therefrom by a gap or space 24A. Connected to the outer segment 22 is a first source of power 28. Similarly, a second source of power 30 is connected to the second electrode segment 24 and a third source of power 32 is connected to the central electrode segment 25. Thus, each of the segments 22-25 can be powered independently with respect to one another.

The advantage of using concentric electrode segments, is that circular semiconductor wafers can be processed uniformly and expeditiously. It should be understood that, while a concentric configuration is shown in FIGURE 3 and a rectangular configuration in FIGURES 1 and 2, any other polygonal configuration using concentric polygons can be used. For example triangles, hexagons, septagons, octagons, and the like are also contemplated and should be considered to be within the scope of the appended claims.

Referring now also to FIGURE 4 there is shown a plan view of an alternate example of an electrode having outer segments partially surrounding a central segment. In particular, the outer electrode segment 34 of this embodiment has three sides. Within the outer electrode 34 is disposed a second electrode segment 36 also having three sides but being smaller in both dimensions. Finally, within the second electrode segment 36 is the central electrode segment 38. Separating the outer electrode 34 and second electrode 36 is a space 34A. Similarly a space 36A separates the second electrode segment 36 from the central segment 38.

In plasma processing prepatterned samples or workpieces, it is often necessary or advantageous to adjust the electrodes in a manner similar to that shown in FIGURE 4. This occurs specifically when the workpiece, circuit lines, vias and through-holes or drilled holes are not symmetrical in both X and Y dimensions.

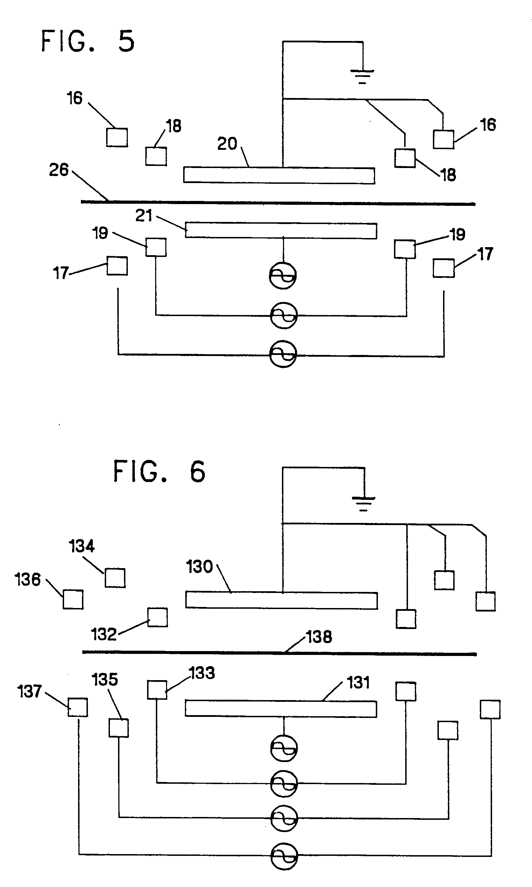

Referring now also to FIGURE 5 there is shown an exploded cross-sectional view of the segmented electrode structure 12 shown in FIGURES 1 and 2 in which the electrodes 16-20 are spaced from one another so that no two of them are co-planar. The workpiece 26 is shown without support in this FIGURE for purposes of diagrammatic simplicity. Suitable and conventional mounting mechanisms would normally be used. The electrode segments 16, 18 and 20 are disposed above the workpiece 26. Another set of electrodes 17, 19 and 21 is disposed symmetrically below the workpiece 26, forming a mirror image of the upper electrodes and corresponding to the upper electrode segments. In the preferred embodiment, one set of segments 16, 18, 20 is grounded and one set 17, 19, 21 is powered. In this configuration, both major surfaces of the workpiece 26 can be processed simultaneously.

Separately controlled segments 17, 19 and 21 can be energized at different times to achieve uniformity of etching or deposition. In this way, the central portion, needing greater processing time, could be initiated first and outer portions could be sequentially powered up; or the entire area could be powered up initially and power could be removed from the outer segments sequentially. Other powering up schemes or strategies could be used depending on workpiece patterns and requirements. In a preferred embodiment, in order to etch material from the center of a workpiece 26 to the same extent as the edges thereof are etched, electrode 20 is positioned closest to the workpiece 26. Electrode 18, which surrounds electrode 20, is spaced at a slightly greater distance from the workpiece 26. Similarly, electrode 16 surrounds the central electrodes 18 and 20 and is positioned at a successively greater distance from the workpiece 26.

Referring now also to FIGURE 6, there is shown an alternate example. Electrode 130 is positioned closest to a workpiece 138. Electrode 132 is placed slightly closer to the workpiece 138. Electrodes 134 and 136 are both placed at greater distances from electrode 130, but not at progressively greater distances from the workpiece 138. All of these electrodes 130, 132, 134 and 136 are grounded. Disposed on the lower side of the workpiece 138 are four powered electrodes 131, 133, 135 and 137.

The powered, lower electrode segments 131-137 are located in a substantially symmetrical panel to the grounded, upper electrode segments 130-136 with respect to the workpiece 138 in this example. It should be understood, however, that symmetry is not necessarily required for operability. In fact, it can be seen that any configuration of electrodes relative to one another and relative to a workpiece can be devised in accordance with the present invention depending upon the purpose for which the reactor chamber is used.

Since other modifications and changes varied to fit particular operating requirements and environments will be apparent to those skilled in the art, the invention is not considered limited to the example chosen for purposes of disclosure, and covers all changes and modifications which do not constitute departures from the scope of the appended claims.

## Claims

1. A reactor providing a uniform field of energized gas for plasma processing comprising:
a) a reactor chamber;
b) means for mounting a workpiece in a plane within said chamber to be exposed to said uniform field of energized gas;
c) a plurality of electrodes in operative relationship to said mounting means with at least two of said electrodes having different distances to said mounting means, whereby all but the outer-most projection of said electrodes onto said plane being at least partially and sequentially surrounded by succeeding projections of the electrodes positioned further out wherein the electrodes of said plurality of electrodes are movable to be positioned with respect to one another and/or to the workpiece in order to adjust and control the plasma field according to the workpiece specialities.

2. The reactor according to claim 1, wherein said plurality of electrodes comprises a first and a second electrode.

3. The reactor according to claim 1 or 2 wherein said plurality of electrodes comprises
grounded electrode means, said grounded electrode means being segmented with the segmented portions of said grounded electrode means being preferably co-planar and
powered electrodes.

4. The reactor according to claim 3, wherein each of said powered electrodes is operatively associated with one segment of said grounded electrode means, respectively.

5. The reactor according to any one of claims 1 to 4 further comprising:
d) means for supplying power to one or several of said plurality of electrodes.

6. The reactor according to claim 5 further comprising:
means for controlling said power supply means to initiate and maintain a plasma region operatively associated with each of said plurality of electrodes.

7. The reactor according to claim 6 wherein said controlling means is adapted to energize each of the electrodes being connected to the means for supplying power sequentially or simultaneously and differentially.

8. The reactor according to any one of claims 1 to 7 further comprising:
e) a target comprising material, preferably a metal, to be deposited on a workpiece, said target being in cooperative relationship with each of said electrodes and affixed thereto.

9. The reactor according to any one of claims 1 to 8 wherein each of said plurality of electrodes are rectilinear or polygonal in shape or have curved boundaries, and wherein preferably a part of said plurality of electrodes is disposed in the same plane.

10. The reactor according to any one of claims 1 to 9 wherein said plurality of electrodes are located in a substantially symmetrical panel with respect to said workpiece.

## Patentansprüche

1. Reaktor zur Bereitstellung eines gleichförmigen Feldes von angeregtem Gas zur Plasmabearbeitung mit:
a) einer Reaktorkammer;
b) Mitteln zum Befestigen eines Werkstückes in einer Ebene innerhalb der Kammer, das dem gleichförmigen Feld von angeregtem Gas ausgesetzt werden soll;
c) einer Mehrzahl von Elektroden, die in funktioneller Beziehung zu den Befestigungsmitteln stehen, wobei wenigstens zwei der Elektroden verschiedene Abstände zu den Befestigungsmitteln besitzen, wodurch alle außer der äußersten Projektion der Elektroden auf die Ebene wenigstens teilweise und sequentiell von nachfolgenden Projektionen der weiter außen positionierten Elektroden umgeben sind, wobei die Elektroden der Mehrzahl von Elektroden beweglich sind, um sie in Bezug zueinander und/oder zu dem Werstück zu positionieren und so das Plasmafeld gemäß den Eigenheiten des Werkstücks einzustellen und zu steuern.

2. Reaktor gemäß Anspruch 1, wobei die Mehrzahl von Elektroden eine erste und eine zweite Elektrode beinhaltet.

3. Reaktor gemäß Anspruch 1 oder 2, wobei die Mehrzahl von Elektroden beinhaltet
geerdete Elektrodenmittel, wobei die geerdeten Elektrodenmittel segmentiert sind, wobei die segmentierten Teile der geerdeten Elektrodenmittel vorzugsweise koplanar sind und
spannungsbeaufschalgte Elektroden.

4. Reaktor gemäß Anspruch 3, wobei jede der spannungsbeaufschlagten Elektroden jeweils mit einem Segment der geerdeten Elektrodenmittel funktionell verknüpft ist.

5. Reaktor gemäß irgendeinem der Ansprüche 1 bis 4, der des weiteren beinhaltet:
d) Mittel zur Stromversorgung einer oder mehrerer der Mehrzahl von Elektroden.

6. Reaktor gemäß Anspruch 5, der des weiteren beinhaltet:
Mittel zum Steuern der Stromversorgungsmittel, um einen Plasmabereich zu erzeugen und aufrechtzuerhalten, der mit jeder der Mehrzahl von Elektroden funktionell verknüpft ist.

7. Reaktor gemäß Anspruch 6, wobei die Steuermittel dafür eingerichtet sind, jede der mit den Stromversorgungsmitteln verbundenen Elektroden sequentiell oder gleichzeitig und unterschiedlich anzusteuern.

8. Reaktor gemäß irgendeinem der Ansprüche 1 bis 7, der des weiteren beinhaltet:
e) ein Target, das Material enthält, vorzugsweise ein Metall, das auf einem Werstück aufzubringen ist, wobei das Target mit jeder der Elektroden in zusammenwirkender Beziehung steht und daran angebracht ist.

9. Reaktor gemäß irgendeinem der Ansprüche 1 bis 8, wobei jede der Mehrzahl von Elektroden von geradliniger oder polygonaler Gestalt ist oder gekrümmte Ränder aufweist und wobei vorzugsweise ein Teil der Mehrzahl von Elektroden in der gleichen Ebene angeordnet ist.

10. Reaktor gemäß irgendeinem der Ansprüche 1 bis 9, wobei die Mehrzahl von Elektroden in einem bezüglich des Werkstücks im wesentlichen symmetrischen Feld angeordnet ist.

## Revendications

1. Réacteur produisant un champ uniforme de gaz activé énergétiquement pour effectuer un traitement au plasma, comprenant :
a) une chambre de réacteur;
b) des moyens pour monter une pièce à usiner dans un plan à l'intérieur de la chambre et pour l'exposer audit champ uniforme de gaz activé énergétiquement;
c) une pluralité d'électrodes placées en relation fonctionnelle vis-à-vis dudit moyen de montage avec au moins deux desdites électrodes ayant des espacements différents vis-à-vis dudit moyen de montage, de manière que surtout la saillie la plus extérieure desdites électrodes sur ledit plan soit au moins partiellement et séquentiellement entourée par des saillies successives des électrodes positionnées encore plus à l'extérieur, dans lequel les électrodes de ladite pluralité d'électrodes sont déplaçables pour être positionnées les unes par rapport aux autres et/ou par rapport à la pièce à usiner, de manière à ajuster et à contrôler/commander le champ de plasma selon les caractéristiques de la pièce à usiner.

2. Réacteur selon la revendication 1, dans lequel la pluralité d'électrodes comprend une première et une deuxième électrodes.

3. Réacteur selon la revendication 1 ou 2, dans lequel la pluralité d'électrodes comprend
des moyens formant électrodes mis à la masse, lesdits moyens formant électrodes mis à la masse étant segmentés, les parties segmentées desdits moyens formant électrodes mis à la masse étant de préférence co-planaires, et
des électrodes alimentées électriquement.

4. Réacteur selon la revendication 3, dans lequel chacune desdites électrodes alimentées électriquement est associée fonctionnellement à un segment dudit moyen formant électrode mis à la masse, respectivement.

5. Réacteur selon l'une quelconque des revendications 1 à 4, comprenant en outre :
d) des moyens pour fournir une puissance électrique à une ou plusieurs parmi la pluralité d'électrodes.

6. Réacteur selon la revendication 5, comprenant en outre :
des moyens pour commander/contrôler lesdits moyens de fourniture de puissance pour initier et maintenir une zone de plasma associée fonctionnellement à chacune parmi ladite pluralité d'électrodes.

7. Réacteur selon la revendication 6, dans lequel ledit moyen de commande est adapté pour activer énergétiquement chacune desdites électrodes reliées aux moyens d'alimentation de puissance électrique, séquentiellement ou simultanément et de façon différentiée.

8. Réacteur selon l'une quelconque des revendications 1 à 7, comprenant en outre :
e) une cible constituée d'un matériau, de préférence un métal, déposé sur la pièce à usiner, ladite cible étant en relation fonctionnelle avec chacune desdites électrodes et étant fixée sur celle-ci.

9. Réacteur selon l'une quelconque des revendications 1 à 8, dans lequel chacune parmi ladite pluralité d'électrodes sont de forme rectiligne ou polygonale ou présentent des limites incurvées et dans lequel de préférence une partie de ladite pluralité d'électrodes est disposée dans le même plan.

10. Réacteur selon l'une quelconque des revendications 1 à 9, dans lequel ladite pluralité d'électrodes sont situées en constituant un panneau sensiblement symétrique par rapport à ladite pièce à usiner.
